# EUROPEAN PATENT APPLICATION

(11) **EP 2 490 513 A2**
(43) Date of publication of application: **22.08.2012**
(21) Application number: 12155780.5
(22) Date of filing: 16.02.2012
(51) Int. Cl.: H05K 1/05, H05K 1/03, H05K 3/38

(54) **Light and heat resistant circuit board apparatus and method**

(30) Priority: 20.02.2011 US 201161444763 P
(71) Applicant: Essence Solar Solutions Ltd., 46120 Herzylia (IL)
(72) Inventor: Halahmi, Izhar, 45373 Hod Hasharon (IL); Helfan, Ron, 47231 Ramat Hasharon (IL); Hasin, Slava, 49444 Petach Tikva (IL)
(74) Representative: Graf Glück Habersack Kritzenberger

(57) **Abstract**

A light and heat resistant circuit board apparatus LHRPCB, comprising: at least one thermally conductive material (TCM) layer (20) adapted to serve as a mechanical and thermal substrate for the LHRPCB; at least one layer (30) of electrically isolating material (EIM) configurable on respective TCM layers, the at least one EIM layer being resistant to UV radiation; at least one electrically conducting (ECL) layer (35) configurable above the at least one TCM layer and adapted to be patterned and to selectively conduct electrical current; at least one heat and UV radiation resistant bonding (HUVRBL) layer (25) appliable between respective ECL, TCM, and EIM layers; and at least one electronic component (45,51) mountable upon the at least one ECL layer, wherein the LHRPCB is adapted to be exposed to light and heat for an extended period.

## Description

### FIELD AND BACKGROUND OF THE INVENTION

Embodiments of the current invention are related to printed circuit board structure and fabrication. More specifically, embodiments of the current invention relate to a light and heat resistant circuit board apparatus and method.

Thermally conductive printed circuit boards (PCBs, for plural and PCB, for singular) are widely used in electronic, solar energy, and electric applications. In the specification and claims which follow the term "PCB" is used interchangeably with "printed wiring board" and to "PWB" and has the same general meaning. In some applications, especially in the field of solar energy applications, a PCB is exposed for extended periods (ranging from individual months to 25 years) to elevated temperatures and high intensity light. In the specification and claims which follow, the term "light", also as used in "sunlight" or "UV light", is intended to have the meaning of "radiation" with respect to various sunlight wavelengths, such as, but not limited to: infra-red (IR), visible, and ultra violet (UV).

Exposure for extended periods to elevated temperatures and high intensity light is even more critical with applications of concentrated solar power and photovoltaics (also known as CSP and CPV) where a PCB is exposed to concentrated sunlight having intensities ranging from 1 sun to 1,000 suns. The term "sun" as used in the context of "sunlight intensity" or similar terms in the specification and the claims which follow is intended to mean a resultant equivalent radiation intensity obtained from incident sunlight being concentrated by the use of optics, for example, from 1 to 1,000 times.

PCB materials currently known in the art are chosen to provide dimensional stability, solderability to electronic components in general and semiconductor packages specifically, and have controlled dielectric constant properties. Unfortunately, most conventional organic PCB materials (such as but not limited to: epoxy; phenolics; polyimides; and cyanate esters) having the qualities listed above are not resistant to a combination of intense UV light and elevated temperatures, which can range from 40 to 200 or more degrees C above ambient, depending on the thermal management mechanisms utilized with a chosen PCB configuration. An additional concern for PCB failure is due to wide thermal cycling of PCBs in the applications noted hereinabove.

As opposed to the conventional organic PCB materials noted hereinabove, ceramic-material PCBs can exhibit required UV and heat resistance. However such PCB's are currently: (1) expensive; (2) usually limited to dimensions of less than 200 x 200 mm; (3) mechanically brittle; and (4) heavy , having densities of approximately 3,300-3,800 kg/m³ compared to aluminum, which has a density of approximately 2,500-2,800 kg/m³.

There is therefore a long felt need to provide a PCB having the characteristics of: being lightweight; toughness; non-brittleness; having larger dimensions; able to being fabricated at lower cost; and which is additionally resistant to degradation and/or failure after being outdoors for extended periods, including being subject to concentrated sunlight.

### SUMMARY OF THE INVENTION

According to the teachings of the present invention there is provided a light and heat resistant circuit board apparatus LHRPCB, comprising: at least one thermally conductive material (TCM) layer adapted to serve as a mechanical and thermal substrate for the LHRPCB; at least one layer of electrically isolating material (EIM) configurable on respective TCM layers, the at least one EIM layer being resistant to UV radiation; at least one electrically conducting layer (ECL) layer configurable above the at least one TCM layer and adapted to be patterned and to selectively conduct electrical current; at least one heat and UV radiation resistant bonding layer (HUVRBL) appliable between respective ECL, TCM, and EIM layers; and at least one electronic component mountable upon the at least one ECL layer, wherein the LHRPCB is adapted to be exposed to light and heat for an extended period.

Preferably, the at least one electronic component is chosen from the list including: a PV cell, an LED, a die, a die package, an SMT component, and a semiconductor package. Most preferably, the at least one TCM layer is a material selected from the list including: metal; ceramic; metal matrix composite; and polymeric composite, the at least one TCM layer having heat transfer paths to the environment. Typically, the at least one TCM layer is aluminum having a thickness ranging from substantially 100 to 5,000 microns.

Most typically, the at least one HUVRBL layer is a material selected from the list including: silicone; cyclic olefin: acrylic; ceramic; glass; polyvinyl butyl; ethylene copolymer; and fluorine containing polymers; and the at least one HUVRBL layer has a thickness ranging from substantially 20 to 300 microns. Preferably, the at least one ECL layer is a material chosen from the list including: metal; metal filled polymer; metal filled ceramic; and carbon filled polymer or ceramic, the at least one ECL layer having a thickness ranging from 15 to 100 microns and having an electrically conducting surface finish coating, the coating having a thickness ranging from 0.2 to 10 microns. Most preferably, the at least one EIM layer is selected from materials such as, but not limited to: metal oxide; metal salt; glass; silicone; PDMS, polymer; vapor deposited oxides; and ceramics, and the at least one EIM layer has a thickness substantially ranging from 0.5 to 120 microns. Typically, a PV module is fabricatable on the at least one ECL layer, the PV module comprising: a plurality of PV cells; a module frame enclosing the plurality of PV cells on all sides; and a front sheet configured above the PV cells, the front sheet allowing sunlight to pass onto the enclosed PV cells. Most typically, substantially no evidence of LHRPCB delamination, cracking, and blistering is observable for the extended period. Preferably, the extended period comprises a range of time from individual months to 25 years.

According to the teachings of the present invention there is further provided a method of fabricating a light and heat resistant circuit board apparatus LHRPCB comprising the steps of: taking at least one thermally conductive material (TCM) layer to serve as a mechanical and thermal substrate for the LHRPCB; creating at least one layer of electrically isolating material (EIM) on respective TCM layers, the at least one EIM layer being resistant to UV radiation; creating at least one electrically conducting layer (ECL) layer above the at least one TCM layer and patterning the at least one ECL layer to selectively conduct electrical current; applying at least one heat and UV radiation resistant bonding layer (HUVRBL) between respective ECL, TCM, and EIM layers; and mounting at least one electronic component upon the at least one ECL layer, whereby the LHRPCB is adapted to be exposed to light and heat for an extended period. Most preferably, the at least one electronic component is chosen from the list including: a PV cell, an LED, a die, a die package, an SMT component, and a semiconductor package. Typically, a PV module is fabricated on the at least one ECL layer, the PV module comprising: a plurality of PV cells; a module frame enclosing the plurality of PV cells on all sides; and a front sheet configured above the PV cells, the front sheet allowing sunlight to pass onto the enclosed PV cells. Most typically, substantially no evidence of LHRPCB delamination, cracking, and blistering is observed for the extended period, the extended period ranging from individual months to 25 years.

### BRIEF DESCRIPTION OF THE DRAWINGS AND APPENDICES

The invention is herein described, by way of example only, with reference to the accompanying drawings, wherein:
FIGS 1 and 2 are schematic cross-sectional side views of successive layers of a light and heat resistant PCB (LHRPCB), indicating stages of fabrication of the LHRPCB, in accordance with embodiments of the current invention;
FIGS 3 and 4 are schematic cross-sectional side views of the LHRPCB of FIG 2 having a die and a die package, respectively, mounted thereupon, in accordance with embodiments of the current invention;
FIGS 5 and 6 are schematic cross-sectional side views of the LHRPCB of FIG 2, having a PV module mounted thereupon, in accordance with embodiments of the current invention; and
FIG 7 is a flow chart showing the steps of fabricating a light and heat resistant PCB (LHRPCB), in accordance with an embodiment of the current invention.

### DETAILED DESCRIPTION OF THE PREFERRED EMBODIMENTS

Embodiments of the current invention are related to printed circuit board structure and fabrication. More specifically, embodiments of the current invention relate to a light and heat resistant circuit board apparatus and method.

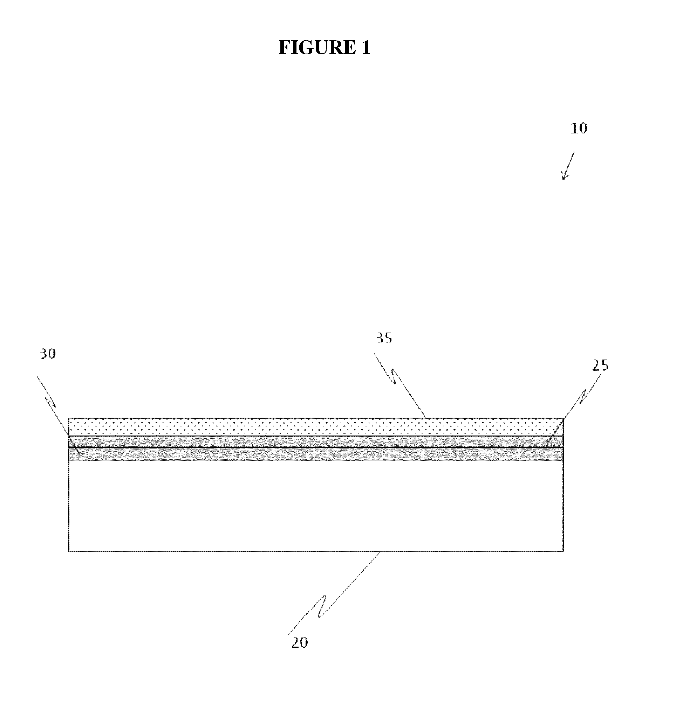

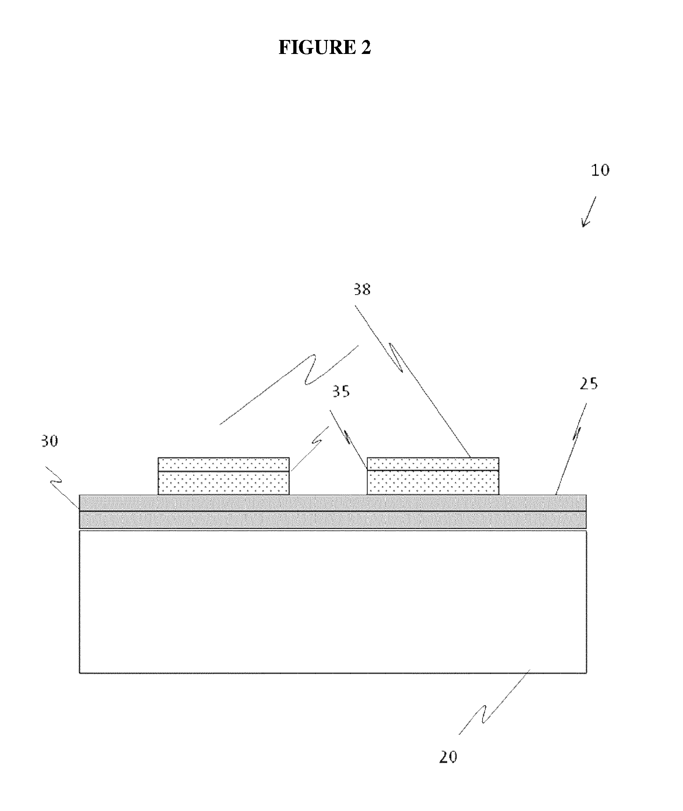

Reference is presently made to FIGS 1 and 2, which are schematic cross-sectional side views of successive layers of a light and heat resistant PCB LHRPCB 10, indicating stages of fabrication of the LHRPCB, in accordance with embodiments of the current invention.

An initial stage of fabricating LHRPCB 10 comprising a TCM layer 20, coated with a HUVRBL layer 25 is seen in FIG 1. The TCM layer serves as a mechanical and thermal substrate, as described hereinbelow. One example of a material for TCM layer 20 is aluminum. An example of material for HUVRBL layer 25 is an addition or condensation type thermoset silicone. Optionally or alternatively, aluminum TCM layer 20 may be anodized prior to HUVRBL layer 25 coating, in which case, the anodized layer is an EIM layer 30. An ECL (electrically conductive layer) 35, such as, but not limited to a copper foil, is laminated to HUVRBL layer 25, which coats TCM layer 20. HUVRBL layer 25 is cross-linked, as known in the art. The following are approximate thickness ranges in embodiments of the current invention: the TCM layer (100 to 5,000 microns); the HUVRBL layer (20 to 200 microns); the EIM layer (0.5 to 120 microns); and the ECL (20 to 100 microns).

In FIG 2, apart from differences described below, LHRPCB 10 is identical in notation, configuration, and functionality to that shown in FIG 1, and elements indicated by the same reference numerals and/or letters are generally identical in configuration, operation, and functionality as described hereinabove. In FIG 2, ECL 35 is patterned, as known in the art. The areas where metal (i.e. part of ECL 35) is removed are UV light and heat resistant because the exposed layer below ECL 35 is HUVRBL layer 25. After etching, ECL 35 is coated, as known in the art, yielding a metal surface finish 38. Typical thickness values at this stage are: the metal foil (15 to 100 microns); and the surface finish (0.2 to 10 microns).

It is important to note that metal patterns can additionally be applied onto cross-linked HUVRBL by direct plating (i.e., pattern plating). Metal surface finish 38 of metal patterns (i.e. ECL 35) optionally comprises a coating having electrically-conductive plating material, which is corrosion resistant and/or provides appropriate pad metallization for the soldering processes. Plating metals can be, inter alia: Tin; Silver; Copper; Bismuth; Nickel; Gold; Palladium; or combinations of metals or alloys. Examples of combinations are: ENIG (Electroless Nickel-Immersion Gold); ENPIG (Electroless Nickel and Palladium- Immersion Gold); SAC (SnAgCu) Hot Air Surface Leveling; IT (Immersion Tin); IN (Immersion Nickel); and others, as known in the art. Plating metals or alloys can be ROHS compliant or non-ROHS compliant.

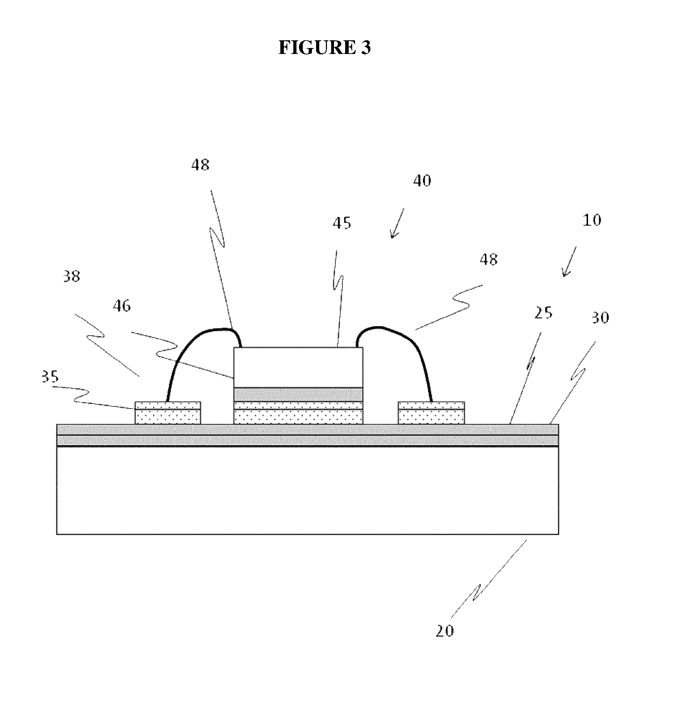

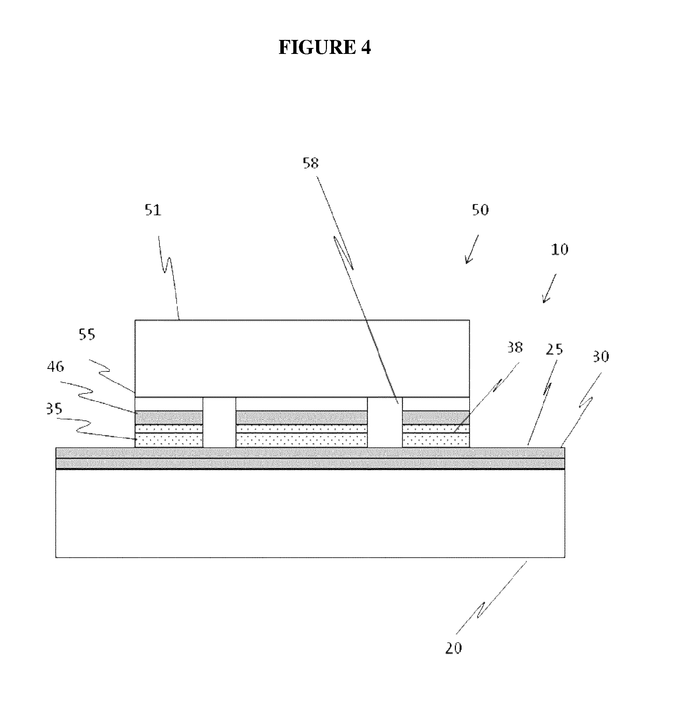

Reference is currently made to FIGS 3 and 4, which are schematic cross-sectional side views of the LHRPCB of FIG 2 having a die 40 and a die package 50, respectively, mounted thereupon, in accordance with embodiments of the current invention. One example of mounting die 40 or die package 50 is a PV cell that is wire bonded, soldered, or glued to metal surface 38 as described hereinbelow.

Die 40 comprises a chip (or "bare die") 45, solder layer 46 serving to fix chip 45 in position onto metal surface 38, and wire bonding 48, all as known in the art. In certain applications, chip 45 is glue-bonded onto metal surface 38-i.e. glue is used in place of solder-all as known in the art. Other examples of chip 45 are a PV cell and an LED.

Die package 50 comprises an SMT component 51 (such as any fabricated surface mounted technology component, as known in the art) having pads 55, which are soldered and/or glue-bonded onto metal surface 38, such as with solder layer 46 serving to solder chip 45 in position. Characteristic air gap 58 is seen in the figure, representing the typical insulating space between pads 55 when SMT component 51 is mounted, as known in the art.

Alternatively or optionally, in an embodiment of the current invention, a PV module 60 (shown in figures hereinbelow) is fabricated, wherein a plurality of PV cells (i.e. plurality of die 40 and die package 50) are soldered or bonded to LHRPCB 10, which serves as a back cover of the PV module, as further described hereinbelow. Such a configuration allows electrical current generated by individual PV components to be conducted by the ECL (currently serving as an interconnect pattern). The individual PV component configuration additionally allows collection and delivery of the charge to a PV module junction box (not shown in the figures), and enables heat to flow through the HUVRBL, EIM, and TCM layers.

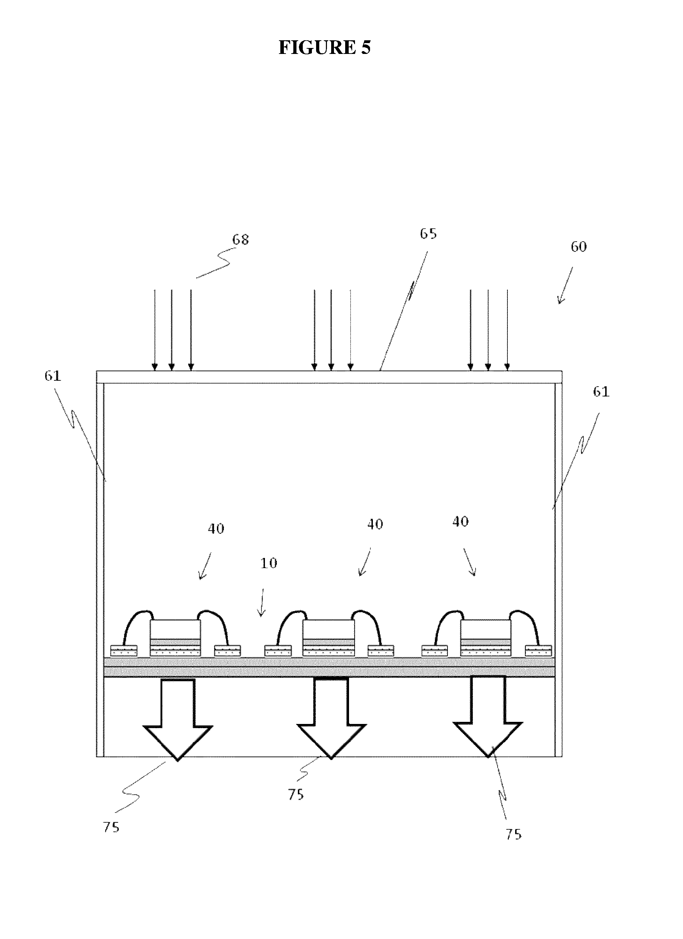

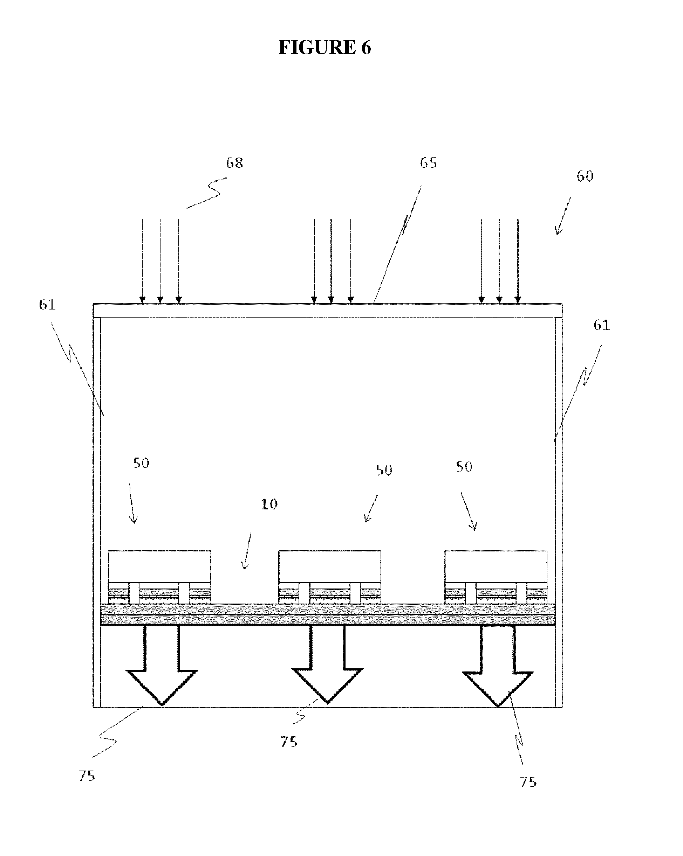

Reference is presently made to FIGS 5 and 6, which are schematic cross-sectional side views of the LHRPCB of FIG 2, having PV module 60 mounted thereupon, in accordance with embodiments of the current invention. Apart from differences described below, LHRPCB 10 is identical in notation, configuration, and functionality to that shown in FIGS 3 and 4, and elements indicated by the same reference numerals and/or letters are generally identical in configuration, operation, and functionality as described hereinabove.

PV module 60 shown in FIG 5 has a plurality of dies 40 mounted on LHRPCB 10, whereas the PV module shown in FIG 6 has a plurality of die packages 50 mounted on LHRPCB 10. In both FIGS 5 and 6, LHRPCB 10 serves as a back-cover of the PV module and as a conducting layer (i.e. "wiring layer") for individual PV components (i.e. plurality of die 40 and die packages 50).

PV module 60 further comprises: a module frame 61, typically enclosing the PV cells on all sides, and front sheet 65, typically configured above the PV cells and being supported by the module frame, as shown in the figure. Sunlight 68 is schematically shown incident to the front sheet. Front sheet 65 is typically formed of plastic or glass material to allow sunlight 68 to pass into PV module 60 and module frame 65 is typically formed of material having a surface to enhance internal reflection of sunlight 68-all as known in the art. Heat transfer paths 75 are indicated, schematically showing how heat is transferred from the PV components (i.e. of die 40 and die packages 50) and through LHRPCB 10 to the environment.

Heat transfer from LHRPCB 10 to the environment may be additionally enhanced by an array of techniques known in the art such as but not limited to: heat sinks, heat pipes, and forced and natural convention.

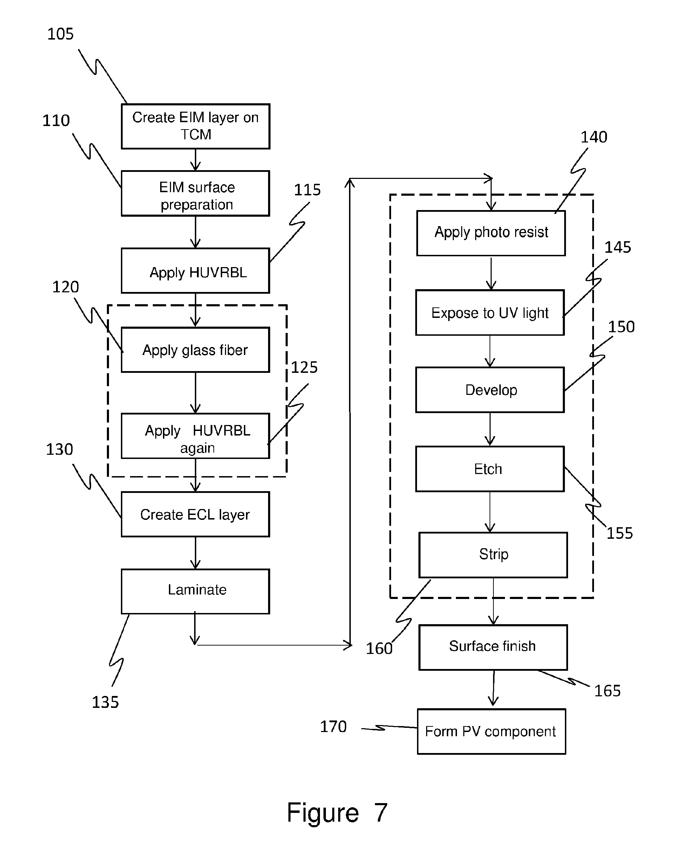

Reference is currently made to FIG 7, which is a flow chart showing the steps of fabricating a light and heat resistant PCB (LHRPCB), such as LHRPCB 10, as described hereinabove in FIGS 1 through 6, in accordance with an embodiment of the current invention.

In step 105, "Create EIM layer on TCM", an exemplary anodized layer (EIM) is created on the TCM. The anodization may be Type 1, 2, or 3, Class 1 or 2, sealed or unsealed. Typically, the anodize thickness ranges from 0.5 to 120 microns. "EIM surface preparation", step 110 then follows, wherein the EIM surface is prepared using mechanical or chemical processes, such as but not limited to: levigation and priming, respectively. In the case of priming, a silicone primer may be used, applied very thinly, and allowing at least 30 minutes for the primer to be activated before proceeding.

In step 115, "Apply HUVRBL", a layer of silicone adhesive is applied on the EIM. Application of the adhesive may be done by brushing or any other suitable technique as known in the art. The silicone adhesive layer should be absent of any air voids.

"Apply glass fiber", step 120, and step 125 "Apply HUVRBL again", are optional steps, as indicated by the dotted enclosure in the figure. Glass fiber (equivalent to "fiberglass" hereinbelow) when used in a PCB, acts to reinforce the polymer matrix (in the present case, the silicone matrix). As reinforcement, fiberglass has electrical, thermal and mechanical benefits, such as:
- Electrical- increasing the dielectric constant (kV/mm)
- Thermal- increasing the operational temperature (C)
- Mechanical- decreasing the coefficient of thermal expansion and increasing the elastic modulus.

In some cases, the properties afforded by the addition of fiberglass are not considered important for end users; in which case fiberglass reinforcement is not required.

A glass fiber sheet, ranging in thickness from 25 to 200 microns, may be applied on top of the HUVRBL applied in step 115. Then, in step 125, "Apply HUVRBL again", a layer of silicone adhesive is again applied, this time over the glass fiber layer. Application of the adhesive may be done by brushing or any other suitable technique as known in the art. The silicone adhesive layer should be absent of any air voids.

In step 130, "Create ECL layer", a metal layer is applied. An exemplary method, as known in the art, is application of a copper foil layer. Copper thickness may range from 35 to 105 microns. Lamination is performed in step 135, wherein the foil is applied to the HUVRBL with an exemplary set of conditions of: approximately 30 minutes' duration; at approximately 150 degrees C; with a pressure of approximately 10 kg/cm².

The following 5 steps, steps 140 through 160, are part of conventional metal patterning, to create conducting patterns on the LHRPCB, as known in the art, as indicated by the dotted enclosure around the 5 steps in the figure. Metal patterning includes the sequence of: "Apply photo resist", step 140; "Expose to UV light", step 145; "Develop", step 150; step 155, "Etch"; and "Strip", step 160. In steps 140, a photo resist layer is selectively applied to the ECL layer to pattern a negative pattern of the desired final metal pattern. In with successive steps 145 and 150, the photo resist is exposed to UV light and developed, as known in the art. Etching, in step 155, serves to remove undesired metal, and the photo resist is then stripped in step 160, all as known in the art.

Following the steps of metal patterning hereinabove, the remaining metal pattern surface is finished in step 165 "Surface finish", whereby the metal surface is finished with metals such as, but not limited to: Tin; Silver; Copper; Bismuth; Nickel; Gold; Palladium; and combination of few metals or alloys, for example: ENIG (Electroless Nickel-Immersion Gold); ENPIG (Electroless Nickel and Palladium- Immersion Gold), HASL materials (Hot Air Surface Leveling); IT (Immersion Tin); and IN (Immersion Nickel). Plating metals or alloys can be ROHS compliant or non ROHS compliant.

In step 170, "Form PV component", one or more PV components, such as described in FIGS 3-6 hereinabove, is/are formed and/or mounted upon the LHRPCB.

An example of fabrication steps of the LHRPCB and of subsequent exposure tests and measurements follows hereinbelow.

### EXAMPLE FABRICATING AND TESTING

An aluminum plate measuring approximately 300 x 300 X 3 mm was anodized using a sulfuric acid anodize, as known in the art. The anodize layer specification is: Type2, Class2 with black pigment, completely sealed, with a thickness of layer of approximately 15 microns. All specifications and processes were performed according to US MIL Specification A-8625F, dated 10 Sept 1993, entitled "Anodic Coatings for Aluminum and Aluminum Alloys" whose disclosure is incorporated herein by reference.

The aluminum plates served as the TCM and the anodize layer as the EIM. Two adhesive options were considered:
- The plate was coated with a thin silicone adhesive layer (refer to Momentive Performance Materials Inc. data sheet for TSE 322S, HCD-10414, (Rev. 1/18/2012 10:27:15 AM), whose disclosure is incorporated herein by reference) having the adhesive layer thickness ranging from 10-50 microns and a thermal conductivity (k) ranging from 0.18-0.25 W/m deg. K .
- The plate was coated with a silicone adhesive layer (refer to Dow Corning Corporation, DC-6751 Data sheet, AGP9702M, Form No. 10-900O-01, whose disclosure is incorporated herein by reference) the adhesive layer having a thickness ranging from 50-300 microns and a thermal conductivity (k) ranging from 1-1.2 W/m deg. K.

A copper foil measuring approximately 35 microns thick was laminated to a glue-coated (HUVRBL) aluminum plate (TCM), with the rough side of the aluminum plate in contact with silicone adhesive and the shiny side of the plate up. The laminate was pressed at approximately 1-10 kg/cm² pressure at approximately 150 Celsius for approximately 30 minutes. Photo-resist was applied and the metal foil was patterned by a standard process of "print and etch", as known in the art. The metal foil was passivated using ENIG plating (Electroless nickel and immersion gold, having approximate thicknesses: Ni: 5 microns and; Au 0.07 microns.

The resultant LHRPCB was exposed to artificial sunlight in a QUV-Chamber [QUV Accelerated Weathering Tester, QLab Corp., Westlake, OH, USA] with UVA340 nm lamps, for approximately 8 hours dry and 4 hours condensation times, black panel temperature of approximately 60 C during dry period and approximately 50 C during condensation period, for approximately 5,000 hours.

No evidence of LHRPCB delamination, cracking, and blistering was observed.

In parallel, a control PCB (made of metal core PCB, FR4 dielectric, epoxy solder mask) was exposed to the same thermal and radiation conditions. Severe delamination, solder mask brittleness, and blistering were observed after 500 hours. After 1,500 hours the outer surface was completely damaged and the PCB was removed from the QUV chamber.

The following information summarizes aspects of the LHRPCB, in accordance with embodiments of the current invention, including:
- Optimally, one layer of thermally conductive material (TCM), but up to 5 TCM layers. Alternatively or optionally, at least one layer of electrically isolating material (EIM) is applied on the surface of respective TCM layers, the EIM layer being resistant to UV radiation;
- At least one electrically conductive layer (ECL), serving as a homogeneous film or as patterned structure, and;
- At least one heat and UV radiation resistant bonding layer (HUVRBL) located between respective ECL, TCM, and EIM layers.
- The TCM layer is selected from materials such as: metal; ceramic; metal matrix composite; polymeric composite; and combinations thereof.
- The EIM layer is selected from materials such as, but not limited to: metal oxide; metal salt; glass; silicone; PDMS, polymer; vapor deposited oxides; and ceramics.
- The ECL layer is selected from materials such as, but not limited to: metal; metal filled polymer; metal filled ceramic; and carbon filled polymer or ceramic.
- The HUVRBL layer is selected from materials such as, but not limited to: silicone; cyclic olefin: acrylic; ceramic; glass; polyvinyl butyl; ethylene copolymer; and fluorine containing polymers, such as PTFE and combinations thereof.

As opposed to the shortcomings of conventional PCB's fabricated from conventional materials described previously, the LHRPCB incorporating EIM and HUVRBL layers made from UV resistant materials, according to embodiments of the present invention exhibits, significantly longer life.

Regarding cost advantages of the LHRPCB, according to embodiments of the current invention, IMS (Integrated Metal Substrates) and MCPCBs (metal core PCB) currently cost from approximately $0.0001 to $ 0.001/square millimeter. Other dual-bonded copper (DBC) ceramic based substrates and\or Kapton® (flex cable) have costs ranging from $0.001 to 0.1/ square millimeter. It is anticipated that devices incorporating embodiments of the current invention will have fabrication costs less than or at the lower end of the ranges noted hereinabove for IMS and MCPCBs, while offering superior thermal management and UV resistance.

It will be appreciated that the above descriptions are intended only to serve as examples, and that many other embodiments are possible within the scope of the present invention as defined in the appended claims.

## Claims

1. A light and heat resistant circuit board apparatus LHRPCB, comprising:
at least one thermally conductive material (TCM) layer adapted to serve as a
mechanical and thermal substrate for the LHRPCB;
at least one layer of electrically isolating material (EIM) configurable on
respective TCM layers, the at least one EIM layer being resistant to UV radiation;
at least one electrically conducting layer (ECL) layer configurable above the
at least one TCM layer and adapted to be patterned and to selectively conduct electrical current;
at least one heat and UV radiation resistant bonding layer (HUVRBL)
appliable between respective ECL, TCM, and EIM layers; and
at least one electronic component mountable upon the at least one ECL layer,
wherein the LHRPCB is adapted to be exposed to light and heat for an extended period.

2. The LHRPCB of claim 1, wherein the at least one electronic component is chosen from the list including: a PV cell, an LED, a die, a die package, an SMT component, and a semiconductor package.

3. The LHRPCB of claim 2, wherein the at least one TCM layer is a material selected from the list including: metal; ceramic; metal matrix composite; and polymeric composite, the at least one TCM layer having heat transfer paths to the environment.

4. The LHRPCB of claim 3, wherein the at least one TCM layer is aluminum having a thickness ranging from substantially 100 to 5,000 microns.

5. The LHRPCB of claim 2, wherein the at least one HUVRBL layer is a material selected from the list including: silicone; cyclic olefin: acrylic; ceramic;
glass; polyvinyl butyl; ethylene copolymer; and fluorine containing polymers; and the at least one HUVRBL layer has a thickness ranging from substantially 20 to 300 microns.

6. The LHRPCB of claim 2 wherein the at least one ECL layer is a material chosen from the list including: metal; metal filled polymer; metal filled ceramic; and carbon filled polymer or ceramic, the at least one ECL layer having a thickness ranging from 15 to 100 microns and having an electrically conducting surface finish coating, the coating having a thickness ranging from 0.2 to 10 microns.

7. The LHRPCB of claim 2 wherein the at least one EIM layer is selected from materials such as, but not limited to: metal oxide; metal salt; glass; silicone; PDMS, polymer; vapor deposited oxides; and ceramics, and the at least one EIM layer has a thickness substantially ranging from 0.5 to 120 microns.

8. The LHRPCB of claim 2, wherein a PV module is fabricatable on the at least one ECL layer, the PV module comprising: a plurality of PV cells; a module frame enclosing the plurality of PV cells on all sides; and a front sheet configured above the PV cells, the front sheet allowing sunlight to pass onto the enclosed PV cells.

9. The LHRPCB of claim 2, wherein substantially no evidence of LHRPCB delamination, cracking, and blistering is observable for the extended period.

10. The LHRPCB of claim 9, wherein the extended period comprises a range of time from individual months to 25 years.

11. A method of fabricating a light and heat resistant circuit board apparatus LHRPCB comprising the steps of:
taking at least one thermally conductive material (TCM) layer to serve as a
mechanical and thermal substrate for the LHRPCB;
creating at least one layer of electrically isolating material (EIM) on
respective TCM layers, the at least one EIM layer being resistant to UV radiation;
creating at least one electrically conducting layer (ECL) layer above the at
least one TCM layer and patterning the at least one ECL layer to selectively conduct electrical current;
applying at least one heat and UV radiation resistant bonding layer
(HUVRBL) between respective ECL, TCM, and EIM layers; and
mounting at least one electronic component upon the at least one ECL layer,
whereby the LHRPCB is adapted to be exposed to light and heat for an extended period.

12. The method of fabricating a LHRPCB according to claim 11, whereby the at least one electronic component is chosen from the list including: a PV cell, an LED, a die, a die package, an SMT component, and a semiconductor package.

13. The method of fabricating a LHRPCB according to claim 12, whereby a PV module is fabricated on the at least one ECL layer, the PV module comprising: a plurality of PV cells; a module frame enclosing the plurality of PV cells on all sides; and a front sheet configured above the PV cells, the front sheet allowing sunlight to pass onto the enclosed PV cells.

14. The method of fabricating a LHRPCB according to claim 13, whereby substantially no evidence of LHRPCB delamination, cracking, and blistering is observed for the extended period, the extended period ranging from individual months to 25 years.
